# EUROPEAN PATENT APPLICATION

(11) **EP 4 614 616 A1**
(43) Date of publication of application: **10.09.2025**
(21) Application number: 23907763.9
(22) Date of filing: 20.12.2023
(51) Int. Cl.: H01M 4/525, H01M 4/505, H01M 4/131, H01M 4/36, H01M 4/48, H01M 4/587, H01M 10/052, H01M 4/02

(54) **POSITIVE ELECTRODE AND LITHIUM SECONDARY BATTERY COMPRISING SAME**

(30) Priority: 21.12.2022 KR 20220181144
(71) Applicant: LG Energy Solution, Ltd., Seoul 07335 (KR)
(72) Inventor: OH, Su Yeon, Daejeon 34122 (KR); LHO, Eun Sol, Daejeon 34122 (KR); HWANG, Jin Tae, Daejeon 34122 (KR); PARK, Byung Chun, Daejeon 34122 (KR); PARK, Sang Min, Daejeon 34122 (KR); LEE, Sang Wook, Daejeon 34122 (KR); KIM, Seul Ki, Daejeon 34122 (KR); KIM, Hyeong Il, Daejeon 34122 (KR)
(74) Representative: Hoffmann Eitle
(86) International application number: PCT/KR2023/021163
(87) International publication number: WO 2024/136480

(57) **Abstract**

A positive electrode according to the present invention may comprise: a lithium nickel-based transition metal oxide in the form of at least one of a single particle made of one single nodule, and a quasi-single particle which is a composite of at most 30 nodules; and a positive electrode active material with a D₅₀ of 4.5 to 6.7 *µ*m and a crystal strain of at most 320x10⁻⁶.

## Description

### TECHNICAL FIELD

This application claims the benefit of Korean Patent Application No. 10-2022-0181144, filed on December 21, 2022, in the Korean Intellectual Property Office, the disclosure of which is incorporated herein in its entirety by reference.

The present invention relates to a positive electrode and a lithium secondary battery including the same, and particularly, to a negative electrode in which a silicon-based negative electrode active material is applied and an available high-capacity low-efficiency positive electrode, and a lithium secondary battery including the same.

### BACKGROUND ART

Recently, interest in energy storage technology has been increasing, and as an application area of the energy storage technology has expanded to energy in a mobile phone, a camcorder, a laptop PC, and even an electric vehicle, an effort to research and develop electrochemical devices is becoming more concrete.

There is growing interest in the development of a secondary battery, among the electrochemical devices, capable of charging and discharging, and in particular, a lithium secondary battery that was developed in the early 1990s is attracting attention due to a high operating voltage and a significantly high energy density.

Recently, as demand for a secondary battery, having a high energy density, such as a battery for the electric vehicle, has increased, development of a high-voltage secondary battery that operates at a high voltage is being actively conducted. In addition, research for applying a silicon-based negative electrode active material having an excellent capacity is being conducted so as to achieve a higher capacity.

The lithium secondary battery for the electric vehicle that has been developed up to now mainly uses a lithium-nickel-based oxide as a positive electrode active material, but when the lithium-nickel-based oxide is applied, limitations such as structural collapse of the positive electrode active material, elution of transition metal, and generation of gas are occurring. In addition, when the silicon-based negative electrode active material is applied, there are limitations in that lithium ions are not rapidly inserted into the inside of a negative electrode due to imbalance in efficiencies of both electrodes, and thus an irreversible process in which the lithium ions are extracted on a surface of the negative electrode occurs so that a side reaction with an electrolyte solution occurs, thereby generating gas and deteriorating room-temperature life characteristics.

### DISCLOSURE OF THE INVENTION

### TECHNICAL PROBLEM

In order to solve the above limitations, an aspect of the present invention provides a positive electrode having a low initial efficiency so as to balance with a negative electrode in which a silicon-based negative electrode active material is applied by including a single-particle positive electrode active material having specific ranges of a D₅₀ and a crystal strain, and a lithium secondary battery including the same.

### TECHNICAL SOLUTION

According to an aspect of the present invention, there is provided a positive electrode including a lithium-nickel-based transition metal oxide having at least one form of a single particle composed of one single nodule, and a pseudo-single particle, which is a composite body of 30 or less nodules, and a positive electrode active material having a D₅₀ of 4.5 µm to 6.7 µm, and a crystal strain of 320x10⁻⁶ or less.

The positive electrode active material may have a D₅₀ of 5.5 µm to 6.5 µm.

The positive electrode active material may have a strain of 220x10⁻⁶ to 320x10⁻⁶.

The positive electrode active material may have a cation mixing ratio of 0.7 at% to 1.2 at%.

The positive electrode active material may have an average grain size of at least 160 nm.

Ni may have a molar ratio of at least 80 mol% among all the transition metals in the lithium-nickel-based transition metal oxide.

The lithium-nickel-based transition metal oxide may be represented by Formula 1 below.

[Formula 1] Li₁₊ₓNiₐCo_{b}M¹_{c}M²_{d}O₂

In Formula 1 above, M¹ may be Mn, Al, or a combination thereof, M² may be at least one selected from the group consisting of Ba, Ca, Zr, Ti, Mg, Ta, Nb, and Mo, 0≤x≤0.50, 0.80≤a<1.00, 0<b<0.20, 0<c<0.20, and 0≤d≤0.20.

The positive electrode may have an initial charging capacity of at least 242 mAh/g.

The positive electrode may have an initial efficiency of 87% to 89%.

According to another aspect of the present invention, there is provided a lithium secondary battery including a positive electrode, a negative electrode, and an electrolyte.

The negative electrode may include a silicon-based negative electrode active material, a carbon-based negative electrode active material, or a combination thereof.

The negative electrode may include a silicon-based negative electrode active material and a carbon-based negative electrode active material.

The lithium secondary battery may have a capacity maintenance rate of at least 88.8% after 50 cycles of charging and discharging are performed with each cycle consisting of charging up to 4.25 V at 0.5 C in a CC-CV mode at 45°C, followed by discharging to 3.0 V at 1.0 C.

### ADVANTAGEOUS EFFECTS

Since each of a positive electrode and a lithium secondary battery according to the present invention includes a positive electrode active material of a single particle having a D₅₀ and a crystal strain in specific ranges, an initial efficiency may decrease so as to balance with a negative electrode in which a silicon-based negative electrode active material is applied, and a lithium precipitation phenomenon may be controlled on a surface of the negative electrode, thereby improving room-temperature life characteristics.

In addition, the lithium precipitation phenomenon caused by a difference in a rate performance may be controlled in the positive electrode and the lithium secondary battery according to the positive electrode, thereby increasing a capacity maintenance rate and improving high-temperature life characteristics.

### BRIEF DESCRIPTION OF THE DRAWINGS

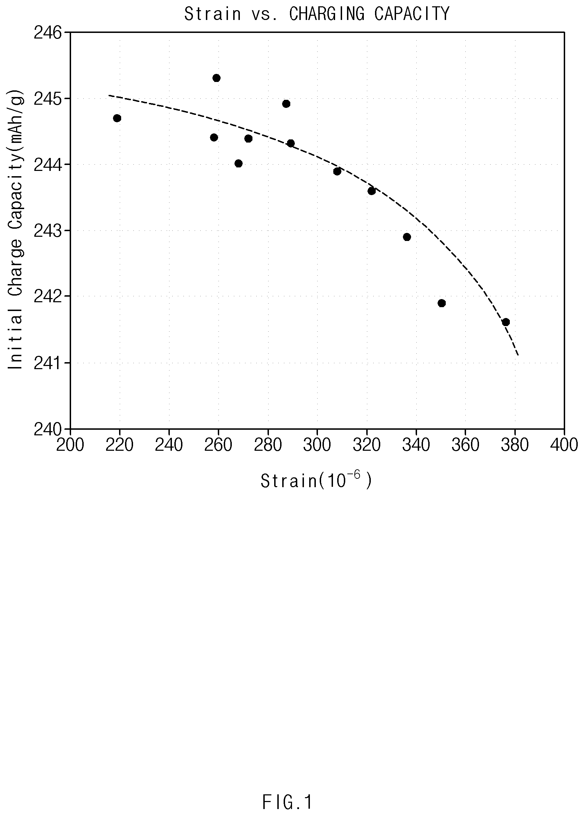

FIG. 1 is a graph showing an initial charging capacity according to a crystal strain of a positive electrode active material.

### MODE FOR CARRYING OUT THE INVENTION

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

According to the present invention, "a single-particle" is a particle composed of one single nodule. According to the present invention, "a pseudo-single-particle" means a composite particle formed of 30 or less nodules.

According to the present invention, "a nodule" means a particle unit body that constitutes the single-particle and the pseudo-single-particle, and may be a single crystal having no crystalline grain boundary, or a polycrystal having no apparent grain boundary when observed using a scanning electron microscope (SEM) at a field of view of 5,000 to 20,000 times. An average diameter of the nodule may be measured as an arithmetic mean value of diameters of the respective nodules measured using a scanning electron microscope (SEM).

According to the present invention, "a secondary particle" means a particle formed by agglomerating tens to hundreds of primary particles, and more specifically, an agglomerated body of at least 40 primary particles.

An expression called as "a particle" used in the present invention may include any one or all of the single-particle, the pseudo-single particle, the primary particle, the nodule, and the secondary particle.

According to the present invention, "a D₅₀" means a grain size with respect to 50% of a volume cumulative grain size distribution of the positive electrode active material. The D₅₀ may be measured using a laser diffraction method. For example, the D₅₀ may be measured by obtaining a grain size corresponding to 50% of a volume cumulative amount after dispersing positive electrode active material powders in a dispersant, introducing to a commercially available laser diffraction grain size measurement device (for example, Microtrac MT 3000) and irradiating 28 kHz ultrasonic waves with an output power of 60 W, and getting a volume cumulative grain size distribution graph.

According to the present invention, "a specific surface area" is measured by a BET method, and may be specifically calculated from an amount of nitrogen gas adsorption under a liquid nitrogen temperature (77K) using BELSORP-mino II from BEL Japan.

According to the present invention, "a crystal strain", "a cation mixing ratio", and "an average grain size" may be measured by analyzing XRD data obtained by X-ray diffraction analysis of the positive electrode active material powders in a Rietveld refinement method. In this case, the X-ray diffraction analysis is measured (FDS of 0.5°, 2θ=15° to 90°, a step size=0.02°, the total scan time: 20 min) using an X-ray diffraction analyzer (Bruker D8 endeavor) after sample powders are put in a groove of a holder for general powders, and a surface of the sample powders is evened using a slide glass, and at the same time, the sample is filled such that a height of the sample powders is equal to the edge of the holder. Rietveld refinement is performed considering, for the measured data, a charge at each site (+3 for metals at a transition metal site, +2 for Ni at an Li site) and cation mixing . Specifically, instrumental broadening during analysis of the crystal strain, the cation mixing ratio, and the average grain size is considered using fundamental parameter approach (FPA) built in a Bruker TOPAS program, and the total peaks in a measurement range are used during fitting. A peak shape is fitted using only Lorentzian contribution among peak types usable in TOPAS as a first principle (FP).

Hereinafter, the present invention will be described in more detail.

### Positive electrode

A positive electrode according to the present invention includes a positive electrode active material. Specifically, the positive electrode includes a positive electrode current collector, a positive electrode active material layer formed on the positive electrode current collector, and the positive electrode active material layer includes the positive electrode active material.

Hereinafter, the positive electrode active material will be described in detail.

The positive electrode active material according to the present invention includes a lithium-nickel-based transition metal oxide having at least one form of a single-particle composed of one single nodule, and a pseudo-single particle which is a composite body of 30 or less nodules.

The lithium-nickel-based oxide having a form of the single-particle and/or the pseudo-single particle has a higher particle strength than a lithium-nickel-based oxide having a form of a typical secondary particle in which tens to hundreds of primary particles are agglomerated, and thus there is less particle breaking during rolling.

In addition, since the lithium-nickel-based oxide according to the present invention having a form of the single-particle or pseudo-single particle has a small number of a sub-component (that is, a nodule) that constitutes a particle, a change caused by volume expansion and contraction of the primary particles during charging and discharging is small, and thus crack generation inside the particle also remarkably decreases.

In particular, the inventors of the present invention discovered that when the positive electrode active material having a D₅₀ of 4.5 µm to 6.7 µm, and a crystal strain of 320x10⁻⁶ or less is applied, an initial efficiency satisfies 87% to 89%, and thus a lithium precipitation phenomenon may be suppressed in a negative electrode in which silicon oxide is applied and a battery constituted therewith, and an energy density may be improved.

The positive electrode active material according to the present invention may have the D₅₀ of 4.5 µm to 6.7 µm, preferably, 4.5 µm to 6.5 µm, and more preferably, 4.6 µm to 6.0 µm. There are limitations that when the D₅₀ is less than 4.5 µm, room-temperature life characteristics are deteriorated, and when the D₅₀ is greater than 6.7 µm, lithium mobility decreases in the positive electrode active material, so that resistance increases and the energy density decreases.

The positive electrode active material according to the present invention has a crystal strain of 320x10⁻⁶ or less, preferably, 220x10⁻⁶ to 320x10⁻⁶, and more preferably, 230x10⁻⁶ to 310x10⁻⁶. There are limitations that when the crystal strain is greater than 320x10⁻⁶, an initial efficiency of the positive electrode is equal to or less than a specific range so that a difference in a rate performance with the negative electrode in which silicon oxide is applied occurs, and thus a lithium plating phenomenon in which lithium is extracted on a surface of the negative electrode occurs and the energy density decreases.

Meanwhile, the positive electrode active material according to the present invention may have a cation mixing ratio of 0.7 at% to 1.2 at%, and preferably, 0.7 at% to 1.1 at%. There may be a limitation that when the cation mixing ratio is less than 0.7 at%, the initial efficiency becomes too high due to high structural completeness, and there is a limitation that when the cation mixing ratio is greater than 1.2 at%, the initial efficiency becomes lower than the target value due to low structural completeness, and an initial resistance increases.

Meanwhile, the positive electrode active material according to the present invention may have an average grain size of at least 160 nm, preferably, 160 nm to 220 nm, and more preferably, 180 nm to 220 nm. There is a limitation that when the average grain size is less than 160 nm, the initial efficiency becomes lower than the target value due to the low structural completeness, and the initial resistance increases.

Meanwhile, the positive electrode active material according to the present invention may include a lithium-nickel-based transition metal oxide, wherein Ni has a molar ratio of at least 80 mol% among all the transition metals in the lithium-nickel-based transition metal oxide.

Meanwhile, the positive electrode active material according to the present invention may include a lithium-nickel-based oxide having a composition of Formula 1 below.

[Formula 1] Li₁₊ₓNiₐCo_{b}M¹_{c}M²_{d}O₂

In Formula 1 above, M¹ may be Mn, Al, or a combination thereof, M² may be at least one selected from the group consisting of Ba, Ca, Zr, Ti, Mg, Ta, Nb, and Mo, 0≤x≤0.50, 0.80≤a<1.00, 0<b<0.20, 0<c<0.20, and 0≤d≤0.20.

The 1+x represents a molar ratio of lithium in the lithium-nickel-based oxide, and 0≤x≤0.50, preferably, 0≤x≤0.30, and more preferably, 0≤x≤0.20.

The a represents a molar ratio of nickel among all metals except for lithium in the lithium-nickel-based oxide, and 0.80≤a<1.00, preferably, 0.83≤a<1.00, and more preferably, 0.86≤a<1.00.

The b represents a molar ratio of cobalt among all metals except for lithium in the lithium-nickel-based oxide, and 0<b<0.20, preferably, 0<b<0.17, and more preferably, 0<b<0.15.

The c represents a molar ratio of M¹ among all metals except for lithium in the lithium-nickel-based oxide, and 0<c<0.20, preferably, 0<c<0.17, and more preferably, 0<c<0.15.

The d represents a molar ratio of element M² among all metals except for lithium in the lithium-nickel-based oxide, and 0≤d≤0.20, preferably, 0≤d≤0.17, and more preferably, 0≤d≤0.15.

Hereinafter, each step of a method for manufacturing a positive electrode active material will be specifically described.

First, after mixing a positive electrode active material precursor and a lithium raw material, a primary firing is performed.

In this case, a precursor such as a commercially available nickel-cobalt-manganese-based hydroxide is purchased and used as a positive electrode active material precursor, or the positive electrode active material precursor may be prepared according to a method for preparing a precursor known in the art such as coprecipitation.

For example, the positive electrode active material precursor may be prepared by adding an ammonium cation-containing complex forming agent and a basic aqueous solution to a transition metal-containing solution including nickel (Ni), cobalt (Co), and a cation of M¹ to perform a coprecipitation reaction.

The transition metal-containing solution may include a nickel-containing raw material, a cobalt-containing raw material, and an M¹-containing raw material, and the M¹-containing raw material may be a manganese-containing raw material and/or an aluminum-containing raw material.

The nickel-containing raw material may be, for example, acetate, nitrate, sulfate, halide, sulfide, hydroxide, oxide, oxyhydroxide, or the like containing nickel, and specifically, may be Ni(OH)₂, NiO, NiOOH, NiCO₃ ·2Ni(OH)₂ ·4H₂O, NiC₂O₂ ·2H₂O, Ni(NO₃)₂ · 6H₂O, NiSO₄, NiSO₄ · 6H₂O, a fatty acid nickel salt, a nickel halide, or a combination thereof, but is not limited thereto.

The cobalt-containing raw material may be acetate, nitrate, sulfate, halide, sulfide, hydroxide, oxide, oxyhydroxide, or the like containing cobalt, and specifically, may be Co(OH)₂, CoOOH, Co(OCOCH₃) ₂ · 4H₂O, Co (NO₃)₂ · 6H₂O, CoSO₄, Co(SO₄)₂ · 7H₂O, or a combination thereof, but is not limited thereto.

The manganese-containing raw material may be, for example, acetate, nitrate, sulfate, halide, sulfide, hydroxide, oxide, or oxyhydroxide containing manganese, or a combination thereof, and specifically, may be: a manganese oxide such as Mn₂O₃, MnO₂, or Mn₃O₄; a manganese salt such as MnCO₃, Mn(NO₃)₂, MnSO₄, manganeseacetate, dicarboxylic acid manganese salt, manganesecitrate, a fatty acid manganese salt; manganeseoxyhydroxide; manganesechloride; or a combination thereof, but is not limited thereto.

The aluminum-containing raw material may be, for example, Al₂O₃, Al(OH)₃, Al(NO₃)₃, Al₂(SO₄)₃, (HO)₂AlCH₃CO₂, HOAl(CH₃CO₂)₂, Al(CH₃CO₂)₃, an aluminum halide, or a combination thereof.

The transition metal-containing solution may be prepared by adding the nickel-containing raw material, the cobalt-containing raw material, and the M¹-containing raw material to a solvent, specifically, water, or a mixed solvent of an organic solvent (for example, alcohol, or the like) capable of being uniformly mixed with water, or may be prepared by mixing an aqueous solution of the nickel-containing raw material, an aqueous solution of the cobalt-containing raw material, and an aqueous solution of the M¹-containing raw material.

The ammonium cation-containing complex forming agent may be, for example, NH₄OH, (NH₄)₂SO₄, NH₄NO₃, NH₄Cl, CH₃COONH₄, NH₄CO₃, or a combination thereof, but is not limited thereto. Meanwhile, the ammonium cation-containing complex forming agent may be used as a form of an aqueous solution, and in this case, water, or a mixture of an organic solvent capable of being uniformly mixed with water (specifically, alcohol, or the like) and water may be used as the solvent.

The basic compound may be a hydroxide of alkali metal or alkaline earth metal such as NaOH, KOH, or Ca(OH)₂, a hydrate thereof, or a combination thereof. The basic compound may be also used as a form of an aqueous solution, and in this case, water, or a mixture of water and an organic solvent (specifically, alcohol, or the like) capable of being mixed with water may be used as the solvent.

The basic compound may be added so as to adjust a pH of a reaction solution, and may be added in an amount such that the pH of the metal solution is 8 to 12.

The coprecipitation reaction may be performed in a nitrogen atmosphere or an inert atmosphere such as argon, at a temperature range of 35°C to 80°C.

The positive electrode active material precursor particles of the nickel-cobalt-M¹ hydroxide are generated by the above process, and are precipitated in a reaction solution. The positive electrode active material precursor having a nickel (Ni) content of the total metal content of at least 60 mol% may be prepared by controlling concentrations of the nickel-containing raw material, the cobalt-containing raw material, and the M¹-containing raw material. The positive electrode active material precursor may be prepared by separating and drying the precipitated positive electrode active material precursor particles in a typical method.

Meanwhile, the positive electrode active material precursor prepared like the above may have a D₅₀ of 4.3 µm to 8.0 µm, preferably, 5.0 µm to 7.5 µm, and more preferably, 5.5 µm to 7.0 µm. When the D₅₀ of the precursor is less than 4.3 µm, there is a higher possibility that the D₅₀ of the positive electrode active material is smaller than an appropriate range, and when the D₅₀ is more than 8.0 µm, since a specific surface area (BET) decreases, reactivity during mixing with the lithium raw material may decrease, so that the structural completeness of the positive electrode active material may be lowered.

Meanwhile, the positive electrode active material precursor may have a specific surface area of 1 m²/g to 15 m²/g, and preferably, 2 m²/g to 15 m²/g. According to the present invention, using a precursor having a smaller specific surface area (BET) than the D₅₀ may be more advantageous in improving the structural completeness of the positive electrode active material.

Thereafter, the positive electrode active material precursor and the lithium raw material may be mixed.

Sulfate, nitrate, acetate, carbonate, oxalate, citrate, a halide, a hydroxide, an oxyhydroxide, or the like containing lithium may be used as the lithium raw material, but as long as being dissolved in water, the lithium raw material is not specially limited. Specifically, the lithium raw material may be Li₂CO₃, LiNO₃, LiNO₂, LiOH, LiOH · H₂O, LiH, LiF, LiCl, LiBr, LiI, CH₃COOLi, Li₂O, Li₂SO₄, Li₃C₆H₅O₇, or the like, and any one or a mixture of at least two thereof may be used.

The positive electrode active material precursor and the lithium raw material may be mixed in a molar ratio of 1:1, 1:1.05, 1:1.10, 1:15, or 1:1.20, but the molar ratio is not limited thereto. When the ratio of mixing metals in the lithium raw material and the positive electrode active material precursor satisfies the above range, a layered crystal structure of the positive electrode active material is well developed so that a positive electrode material having excellent capacity characteristics and structural stability may be prepared.

Thereafter, the mixture may be primarily fired. The primary firing may be performed under air or an oxygen atmosphere. The primary firing is performed under a condition of growing a grain of the positive electrode active material so as to satisfy a grain size range of the present invention.

The primary firing may be performed at a temperature range of 700°C to 1000°C, preferably, 800°C to 900°C, and more preferably, 825°C to 875°C.

The primary firing may be performed for 1 hour to 15 hours, preferably, 6 hours to 15 hours, and more preferably, 10 hours to 15 hours. In the present disclosure, the oxygen atmosphere means not only an atmospheric atmosphere, but also an atmosphere including sufficient oxygen for firing. In particular, it is preferable to perform in an atmosphere having a higher oxygen partial pressure than the atmospheric atmosphere.

It is preferable to perform a grinding process for controlling so as to have a desirable grain size distribution after the firing. In this case, the grinding may be performed through a general grinding known in the art, for example, ball-milling, jet-milling, or the like. When the above grinding process is performed, the grain size of the positive electrode active material may be more appropriately controlled.

Thereafter, the primarily fired material may be secondarily fired. The secondary firing may be performed at a temperature of 500°C to 1000°C, preferably, 600°C to 900°C, and more preferably, 700°C to 800°C.

The secondary firing may be performed for 6 hours to 18 hours, preferably, 8 hours to 16 hours, and more preferably, 10 hours to 14 hours.

Meanwhile, when the lithium composite transition metal oxide containing the M² metal is prepared, the M² metal-containing raw material is additionally mixed during a coprecipitation process or the firing step. In this case, the M² metal-containing raw material may be acetate, carbonate, nitrate, sulfate, a halide, a sulfide, an oxide, or the like of the M² metal.

Since the positive electrode active material has been described in detail, detailed description thereof is omitted, and hereinafter, only the rest of the configuration will be specifically described.

The positive electrode current collector may include a metal having a high conductivity, and as long as being easily bonded to the positive electrode active material layer and not having reactivity in a voltage range of the battery, is not specially limited. For example, stainless steel, aluminum, nickel, titanium, heat-treated carbon, or aluminum or stainless steel of which surfaces are treated with carbon, nickel, titanium, silver, or the like may be used as the positive electrode current collector. In addition, the positive electrode current collector may typically have a thickness of 3 µm to 500 µm, and may have a high adhesion of the positive electrode active material by forming a fine irregularity on the surface thereof. For example, the positive electrode current collector may be used in various forms such as a film, a sheet, a foil, a net, a porous body, a foam, a non-woven fabric.

The positive electrode active material layer may selectively include a conductive material and a binder as needed, together with the positive electrode active material.

In this case, the positive electrode active material may be included in a content of 80 % to 99% by weight, and preferably, 90% to 99% by weight with respect to the total weight of the positive electrode active material layer.

The conductive material is used so as to impart conductivity to an electrode, and as long having an electron conductivity in the constituted battery without causing a chemical change, may be used without special limitation. Graphite such as natural graphite and artificial graphite; a carbon-based material such as carbon black, acetylene black, Ketjen black, channel black, furnace black, lamp black, thermal black, and a carbon fiber; powders or a fiber of a metal such as copper, nickel, aluminum, and silver; a conductive tube such as a carbon nanotube; a conductive whisker such as zinc oxide, and potassium titanate; a conductive metal oxide such as titanium oxide; a conductive polymer such as a polyphenylene derivative, etc., may be specific examples, and one alone or a mixture of at least two thereof may be used. The conductive material may be included in an amount of 0.01% to 10% by weight, preferably, 0.1% to 9% by weight, and more preferably, 0.1% to 5% by weight with respect to the total weight of the positive electrode active material layer.

The binder serves to attach between the positive electrode active material particles and to improve adhesion of the positive electrode active material and the current collector. Polyvinylidenefluoride (PVDF), polyvinylidenefluoride-hexafluoropropylene copolymer (PVDF-co-HFP), polyvinylalcohol, polyacrylonitrile, polymethylmethacrylate, carboxymethylcellulose (CMC), starch, hydroxypropylcellulose, regenerated cellulose, polyvinylpyrrolidone, polytetrafluoroethylene, polyethylene, polypropylene, ethylene-propylene-diene polymer (EPDM), sulfonated-EPDM, styrene butadiene rubber (SBR), fluororubber, polyacrylic acid, and a polymer whose hydrogen is substituted with Li, Na, or Ca, various copolymers thereof, or the like may be specific examples, and one alone or a mixture of at least two thereof may be used. The binder may be included in an amount of 1% to 30% by weight, preferably, 1% to 20% by weight, and more preferably, 1% to 10% by weight with respect to the total weight of the positive electrode active material layer.

The positive electrode may be manufactured in a typical method for manufacturing a positive electrode, except that the positive electrode active material is used. Specifically, the positive electrode may be manufactured by drying and rolling after applying, on the positive electrode current collector, the positive electrode slurry composition prepared by dissolving and dispersing, in a solvent, the positive electrode active material, and selectively the binder, the conductive material, and a dispersant as needed.

The solvent may be a solvent generally used in the art, dimethylsulfoxide (DMSO), isopropylalcohol, N-methylpyrrolidone (NMP), dimethylformamide (DMF), acetone, water, or the like may be the solvent, and one alone or a mixture of at least two thereof may be used. As long as having a viscosity capable of showing excellent thickness uniformity in being applied so as to manufacture the positive electrode after dissolving and dispersing the positive electrode active material, the conductive material, the binder, and the dispersant in consideration of an application thickness of the slurry, and the manufacturing yield, an amount of the solvent is sufficient.

In addition, the positive electrode may be manufactured in another method that the positive electrode slurry composition is cast on a separate support, and a film obtained by being peeled from the support is laminated on the positive electrode current collector.

Meanwhile, the positive electrode according to the present invention may have an initial charging capacity of at least 242 mAh/g, and preferably, 242 mAh/g to 244 mAh/g.

Meanwhile, the positive electrode according to the present invention may have an initial efficiency of 87% to 89%, and preferably, 88% to 89%. When the initial efficiency of the positive electrode according to the present invention satisfies the above range, a lithium precipitation phenomenon may be suppressed in the negative electrode in which the silicon-based negative electrode active material is applied, and the constituted battery, and thus an energy density may be improved.

### Lithium secondary battery

Next, a lithium secondary battery according to the present invention will be described.

The lithium secondary battery specifically includes a positive electrode, a negative electrode disposed opposed to the positive electrode, and a separator and an electrolyte interposed between the positive electrode and the negative electrode, and since the positive electrode is the same as what is described above, detailed description thereof is omitted, and hereinafter, only the rest of the configuration will be specifically described.

In addition, the lithium secondary battery may selectively further include a battery case that accommodates an electrode assembly composed of the positive electrode, the negative electrode, and the separator, and a sealing member that seals the battery case.

In the lithium secondary battery, the negative electrode includes a negative electrode current collector and a negative electrode active material layer placed on the negative electrode current collector.

As long as having a high conductivity without causing a chemical change to a battery, the negative electrode current collector is not specially limited, and for example, copper, stainless steel, aluminum, nickel, titanium, heat-treated carbon, copper or stainless steel of which surfaces are treated with carbon, nickel, titanium, silver, or the like, an aluminum-cadmium alloy, or the like may be used as the negative electrode current collector. In addition, the negative electrode current collector may typically have a thickness of 3 µm to 500 µm, and like the positive electrode current collector, may strengthen adhesion of the negative electrode active material by forming a fine irregularity on the surface of the current collector. For example, the negative electrode current collector may be used in various forms such as a film, a sheet, a foil, a net, a porous body, a foam, or a non-woven fabric.

The negative electrode active material layer selectively includes a binder and a conductive material, together with the negative electrode active material.

The negative electrode active material layer may be disposed on one surface or both surfaces of the negative electrode current collector.

The negative electrode active material may include a silicon-based negative electrode active material, a carbon-based negative electrode active material, or a combination thereof.

The silicon-based negative electrode active material may be Si, SiOₓ (0<x<2), a Si-Q alloy (the Q is an element selected from the group consisting of alkali metal, alkaline earth metal, a Group 13 element, a Group 14 element, a Group 15 element, a Group 16 element, transition metal, a rare earth element, and a combination thereof, and the Q is not Si), or a combination thereof.

The carbon-based negative electrode active material may be a compound capable of reversibly intercalating and deintercalating lithium. A carbonaceous material such as artificial graphite, natural graphite, a graphitized carbon fiber, or amorphous carbon may be a specific example thereof. In addition, low-crystalline carbon and high-crystalline carbon may be all used as the carbonaceous material. Soft carbon and hard carbon are representative as the low-crystalline carbon, and amorphous, plate-shaped, flaky, spherical or fibrous natural graphite or artificial graphite, Kish graphite, pyrolytic carbon, a mesophase pitch-based carbon fiber, a meso-carbon microbead, a mesophase pitch, and high-temperature heat-treated carbon such as petroleum or coal tar pitch derived cokes are representative as the high-crystalline carbon.

The negative electrode active material may be included in an amount of 80% to 99% by weight, preferably, 82% to 99% by weight, and more preferably, 84% to 99% by weight with respect to the total weight of the negative electrode active material layer.

When the negative electrode including the negative electrode active material is combined with the positive electrode having the above-described initial efficiency of 87% to 89%, a lithium precipitation phenomenon may be suppressed on the negative electrode surface, thereby performing a high energy density.

The binder is a component helping bonding between the conductive material, the active material, and the current collector, and is typically added in an amount of 0.1% to 10% by weight with respect to the total weight of the negative electrode active material layer. Polyvinylidenefluoride (PVDF), polyvinylalcohol, carboxymethylcellulose (CMC), starch, hydroxypropylcellulose, regenerated cellulose, polyvinylpyrrolidone, polytetrafluoroethylene, polyethylene, polypropylene, ethylene-propylene-diene polymer (EPDM), sulfonated-EPDM, styrene-butadiene rubber, nitrile-butadiene rubber, fluoroelastomer, and various copolymers thereof may be examples of the binder.

The conductive material is a component for further improving a conductivity of the negative electrode active material, and may be included in an amount of 1% to 30% by weight, preferably, 1% to 20% by weight, and more preferably, 1% to 10% by weight with respect to the total weight of the negative electrode active material layer. As long as having a conductivity without causing a chemical change in the battery, the conductive material is not specially limited, and for example, graphite such as natural graphite or artificial graphite; carbon black such as acetylene black, Ketjen black, channel black, furnace black, lamp black, or thermal black; a conductive fiber such as a carbon fiber or a metal fiber; fluorinated carbon; metal powders such as aluminum or nickel powders; a conductive whisker such as zinc oxide or potassium titanate; a conductive metal oxide such as titanium oxide; a conductive material such as a polyphenylene derivative, or the like may be used as the conductive material.

The negative electrode active material layer may be manufactured by applying, on the negative electrode current collector, a negative electrode slurry composition prepared by dissolving or dispersing, in a solvent, the negative electrode active material, and selectively the binder and the conductive material, and drying, or may be manufactured by laminating, on the negative electrode current collector, a film obtained by casting the negative electrode slurry composition on a separate support and then peeling from the support.

Meanwhile, in the lithium secondary battery, the separator separates the negative electrode and the positive electrode, and supplies a moving path of lithium ions. As long as being used as a separator in a typical lithium secondary battery, it may be used as the separator without special limitation, and in particular, it is preferable to have a low resistance to ion movement in the electrolyte and have excellent electrolyte moisturizing ability. Specifically, for example, a porous polymer film prepared of a polyolefin-based polymer such as ethylene homopolymer, propylene homopolymer, ethylene/butene copolymer, ethylene/hexene copolymer, and ethylene/methacrylate copolymer, or at least two layered stack structure thereof may be used. In addition, a typical porous non-woven fabric, for example, a non-woven fabric made of a glass fiber having a high melting point, a polyethyleneterephthalate fiber, or the like may be used. In addition, an applied separator including a ceramic component or a polymer material may be used so as to secure a heat resistance or a mechanical strength, and the separator may be selectively used as a single-layered or multi-layered structure.

In addition, the electrolyte used in the present invention may be an organic liquid electrolyte, an inorganic liquid electrolyte, a solid polymer electrolyte, a gel-type polymer electrolyte, a solid inorganic electrolyte, and a molten inorganic electrolyte usable in manufacturing the lithium secondary batteries, but is not limited thereto.

Specifically, the electrolyte may include an organic solvent and a lithium salt.

As long as serving as a medium capable of moving ions involved in an electrochemical reaction of the battery, the organic solvent may be used without special limitation. Specifically, an ester-based solvent such as methylacetate, ethylacetate, γ-butyrolactone, or ε-caprolactone; an ether-based solvent such as dibutylether or tetrahydrofuran; a ketone-based solvent such as cyclohexanone; an aromatic hydrocarbon-based solvent such as benzene or fluorobenzene; a carbonate-based solvent such as dimethylcarbonate (DMC), diethylcarbonate (DEC), methylethylcarbonate (MEC), ethylmethylcarbonate (EMC), ethylenecarbonate (EC), or propylenecarbonate (PC); an alcohol-based solvent such as ethylalcohol or isopropylalcohol; a nitrile such as R-CN (the R is a straight-chained, branched or ring-structured hydrocarbon group having 2 to 20 carbon atoms, and may include a double bond aromatic ring or ether bond); an amide such as dimethylformamide; a dioxolane such as 1,3-dioxolane; a sulfolane, or the like may be used as the organic solvent. Thereamong, the carbonate-based solvent is preferable, and a mixture of a cyclic carbonate-based compound (for example, ethylenecarbonate, or propylenecarbonate) having a high ionic conductivity and a high permittivity so as to improve a charging and discharging performance of the battery, and a linear carbonate-based compound (for example, ethylmethylcarbonate, dimethylcarbonate, diethylcarbonate, or the like) having a low viscosity is more preferable.

As long as being a compound capable of supplying lithium ions used in the lithium secondary battery, the lithium salt may be used without special limitation. Specifically, an anion of the lithium salt may be at least one selected from the group consisting of F⁻, Cl⁻, Br⁻, I⁻, NO₃⁻, N(CN)₂⁻, BF₄⁻, CF₃CF₂SO₃⁻, (CF₃SO₂)₂N⁻, (FSO₂)₂N⁻, CF₃CF₂(CF₃)₂CO⁻, (CF₃SO₂)₂CH⁻, (SF₅)₃C⁻, (CF₃SO₂)₃C⁻, CF₃(CF₂)₇SO₃⁻, CF₃CO₂⁻, CH₃CO₂⁻, SCN⁻, and (CF₃CF₂SO₂)₂N⁻, and LiPF₆, LiClO₄, LiAsF₆, LiBF₄, LiSbF₆, LiAlO₄, LiAlCl₄, LiCF₃SO₃, LiC₄F₉SO₃, LiN(C₂F₅SO₃)₂, LiN(C₂F₅SO₂)₂, LiN(CF₃SO₂)₂, LiCl, LiI, LiB(C₂O₄)₂, or the like may be used as the lithium salt. It is preferable to use the lithium salt in a range of a concentration of 0.1 M to 4.0 M, preferably, 0.5 M to 3.0 M, and more preferably, 1.0 M to 2.0 M. Since when the concentration of the lithium salt is included in the above range, the electrolyte has appropriate conductivity and viscosity, an excellent electrolyte performance may be exhibited, and the lithium ions may effectively move.

In addition to the above electrolyte components, for example, at least one additive such as a haloalkylenecarbonate-based compound such as difluoroethylenecarbonate, pyridine, triethylphosphite, triethanolamine, cyclic ether, ethylenediamine, n-glyme, hexanoicacidtriamide, a nitrobenzene derivative, sulfur, a quinoneimine dye, N-substituted oxazolidinone, N,N-substituted imidazolidine, ethyleneglycoldialkylether, an ammonium salt, pyrrole, 2-methoxyethanol, aluminum trichloride, or the like may be further included in the above electrolyte on the purpose of improving life characteristics of the battery, suppressing decrease of a battery capacity, improving a discharging capacity of the battery, etc. In this case, the additive may be included in an amount of 0.1% to 10.0% by weight with respect to the total weight of the electrolyte.

As described above, the lithium secondary battery including the positive electrode according to the present invention has a high charging capacity to perform a high energy density, and thus is useful in a portable device such as a mobile phone, a laptop computer, a digital camera, and an electric vehicle such as a hybrid electric vehicle (HEV).

Accordingly, according to another embodiment of the present invention, a battery module including the lithium secondary battery as a unit cell, and a battery pack including the same are supplied.

The battery module and the battery pack may be used as a medium to large device power of at least any one among a power tool; an electric vehicle including an electric vehicle (HV), a hybrid electric vehicle, and a plug-in hybrid electric vehicle (PHEV); and a system for storing power.

Hereinafter, embodiments of the present invention will be described in detail such that those skilled in the art may easily implement the present invention. However, the present invention may be implemented in many different forms, and is not limited to the embodiments described herein.

### Examples and Comparative Examples

### Example 1

A lithium-nickel-based transition metal hydroxide precursor having a molar ratio of Ni:Co:Mn of 90:6:4 and a D₅₀ of 4.3 µm, and a lithium raw material LiOH were mixed such that a molar ratio of transition metals, (Ni+Co+Mn):Li is 1:1, and then the mixture was primarily fired at 850°C for 4 hours.

Thereafter, the primarily fired product was secondarily fired at 790°C for 10 hours to prepare positive electrode active material powders of LiNi_{0.90}CO_{0.06}Mn_{0.04}O₂.

### Example 2

The positive electrode active material was prepared in the same method as Example 1 above except that the D₅₀ of the lithium-nickel-based transition metal hydroxide precursor was 6.06 µm, the first firing was performed at 850°C for 4 hours, and the second firing was performed at 790°C for 10 hours.

### Example 3

The positive electrode active material was prepared in the same method as Example 1 above except that the D₅₀ of the lithium-nickel-based transition metal hydroxide precursor was 5.9 µm, the first firing was performed at 830°C for 12 hours, and the second firing was performed at 780°C for 12 hours.

### Example 4

The positive electrode active material was prepared in the same method as Example 1 above except that the D₅₀ of the lithium-nickel-based transition metal hydroxide precursor was 5.9 µm, the first firing was performed at 810°C for 12 hours, and the second firing was performed at 750°C for 8 hours.

### Example 5

The positive electrode active material was prepared in the same method as Example 1 above except that the D₅₀ of the lithium-nickel-based transition metal hydroxide precursor was 5.5 µm, the first firing was performed at 810°C for 12 hours, and the second firing was performed at 750°C for 8 hours.

### Example 6

The positive electrode active material was prepared in the same method as Example 1 above except that the D₅₀ of the lithium-nickel-based transition metal hydroxide precursor was 6.06 µm, the first firing was performed at 850°C for 4 hours, and the second firing was performed at 820°C for 9.7 hours.

### Example 7

The positive electrode active material was prepared in the same method as Example 1 above except that the D₅₀ of the lithium-nickel-based transition metal hydroxide precursor was 5.9 µm, the first firing was performed at 820°C for 7 hours, and the second firing was performed at 750°C for 8 hours.

### Comparative Example 1

The positive electrode active material was prepared in the same method as Example 1 above except that the D₅₀ of the lithium-nickel-based transition metal hydroxide precursor was 3.5 µm, the first firing was performed at 830°C for 6 hours, and the second firing was performed at 780°C for 9 hours.

### Comparative Example 2

The positive electrode active material was prepared in the same method as Example 1 above except that the D₅₀ of the lithium-nickel-based transition metal hydroxide precursor was 9.0 µm, the first firing was performed at 830°C for 6 hours, and the second firing was performed at 780°C for 9 hours.

### Comparative Example 3

The positive electrode active material was prepared in the same method as Example 1 above except that the D₅₀ of the lithium-nickel-based transition metal hydroxide precursor was 9.0 µm, the first firing was performed at 800°C for 6 hours, and the second firing was performed at 780°C for 9 hours.

### Comparative Example 4

The positive electrode active material was prepared in the same method as Example 1 above except that the D₅₀ of the lithium-nickel-based transition metal hydroxide precursor was 6.06 µm, the first firing was performed at 850°C for 4 hours, and the second firing was performed at 790°C for 9.7 hours.

D₅₀, crystalline strains, and average grain sizes of the positive electrode active materials according to Example 1 to 7 and Comparative Examples 1 to 4 described above were measured. The measurement results were shown in Table 1 below. A graph of an initial charging capacity according to the crystal strain of the positive electrode active material was shown in FIG. 1.

The D₅₀ may be defined as a particle size corresponding to 50% of a volume cumulative particle size distribution of the positive electrode active material, and may be measured using a laser diffraction method. For example, the D₅₀ of the positive electrode active material may be measured by obtaining a particle size corresponding to 50% of a volume cumulative amount in a measurement device after dispersing positive active material particles in a dispersant, introducing to a commercially available laser diffraction particle size measurement device (for example, Microtrac MT 3000), and irradiating ultrasonic waves having a frequency of about 28 kHz with an output power of 60 W.

The crystal strain, the cation mixing ratio, and the average grain size may be measured by analyzing XRD data obtained through X-ray diffraction analysis by Cu K_{α} X-rays in a Rietveld refinement method. In this case, the X-ray diffraction analysis is measured (FDS of 0.5°, 2θ=15° to 90°, a step size=0.02°, the total scan time: 20 min) using an X-ray diffraction analyzer (Bruker D8 endeavor) after sample powders are put in a groove of a holder for general powders, and a surface of the sample powders is evened using a slide glass, and at the same time, the sample is filled such that a height of the sample powders is equal to the edge of the holder. Rietveld refinement was performed considering, for the measured data, a charge at each site (+3 for metals at a transition metal site, and +2 for Ni at an Li site), and cation mixing. Specifically, instrumental broadening during analysis of the crystal strain, the cation mixing ratio, and the average grain size was considered using fundamental parameter approach (FPA) built in a Bruker TOPAS program, and the total peaks in a measurement range were used during fitting. A peak shape was fitted using only a Lorentzian contribution among peak types usable in TOPAS as a first principle (FP).

**[Table 1]**

| | D₅₀ (µm) | Crystal strain (x 10⁻⁶) | Cation mixing ratio (at%) | Average grain size (nm) |
|---|---|---|---|---|
| Example 1 | 4.67 | 219 | 0.7 | 216 |
| Example 2 | 4.69 | 289 | 1.1 | 166 |
| Example 3 | 5.61 | 296 | 0.5 | 259 |
| Example 4 | 5.64 | 287 | 0.3 | 209 |
| Example 5 | 5.10 | 238 | 0.7 | 217 |
| Example 6 | 5.18 | 308 | 1.2 | 185 |
| Example 7 | 5.61 | 258 | 0.7 | 211 |
| Comparative Example 1 | 3.96 | 268 | 0.7 | 193 |
| Comparative Example 2 | 6.89 | 504 | 1.1 | 142 |
| Comparative Example 3 | 6.80 | 376 | 0.9 | 167 |
| Comparative Example 4 | 5.01 | 336 | 0.7 | 163 |

### Experimental Example 1: Evaluation of initial charging capacity and initial efficiency

Lithium secondary battery coin half cells manufactured as follows using the positive electrode active materials of Examples 1 to 7 and Comparative Examples 1 to 4 described above, were charged to 4.25 V at 0.1 C in a CC-CV mode at 25°C, and discharged to 3.0 V at 1.0 C to evaluate initial charging capacities and initial efficiencies. The measurement results are shown in Table 2 below.

Specifically, the lithium secondary battery coin half cells were manufactured as follows.

A linear dispersion having a solid content of 11.2% by weight was manufactured by mixing, in N-methylpyrrolidone, the positive electrode active materials respectively prepared in Examples 1 to 7 and Comparative Examples 1 to 4 above, a carbon black conductive material, and a PVDF binder having a weight ratio of 97.0:1.5:1.5. Thereafter, the positive electrode slurry was prepared by mixing the linear dispersion and N-methylpyrrolidone (NMP) at a weight ratio of 3:1. The positive electrode was manufactured by applying the positive electrode slurry on one surface of an aluminum current collector, drying at 130°C, and rolling.

A lithium metal was used as the negative electrode.

The coin half cell was manufactured by manufacturing an electrode assembly by interposing a separator between the positive electrode and the negative electrode manufactured like the manufacturing example described above, placing the electrode assembly inside a battery case, and injecting an electrolyte into the case. The electrolyte was manufactured by dissolving LiPF₆ having a concentration of 1 M in a mixed organic solvent in which ethylenecarbonate (EC), dimethylcarbonate (DMC), and diethylcarbonate (DEC) were mixed at a volume ratio of 1:1:1, and adding vinylenecarbonate (VC) of 5% by weight.

### Experimental Example 2: Evaluation of high-temperature life characteristics

The high-temperature life characteristics were evaluated by measuring capacity maintenance rates (%) after 50 cycles of charging and discharging were performed for the coin half cells manufactured in Experimental Example 1 with each cycle consisting of charging up to 4.25 V at 0.5 C in a CC-CV mode at 45°C, followed by discharging to 3.0 V at 1.0 C. The measurement results were shown in Table 2 below.

**[Table 2]**

| | Initial charging capacity (mAh/g) | Initial efficiency (%) | High-temperatur e capacity maintenanc e rate (%) |
|---|---|---|---|
| Example 1 | 244.7 | 88.8 | 89.53 |
| Example 2 | 244.3 | 88.0 | 89.64 |
| Example 3 | 244.8 | 88.2 | 88.30 |
| Example 4 | 244.9 | 88.3 | 87.71 |
| Example 5 | 246.6 | 88.1 | 89.74 |
| Example 6 | 243.9 | 88.3 | 89.86 |
| Example 7 | 244.4 | 88.1 | 89.90 |
| Comparative Example 1 | 244.0 | 90.5 | 88.68 |
| Comparative Example 2 | 237.3 | 85.9 | 86.92 |
| Comparative Example 3 | 241.6 | 86.5 | 91.13 |
| Comparative Example 4 | 242.9 | 89.3 | 88.77 |

Referring to Table 2 above, it may be confirmed that capacity maintenance rates of the positive electrodes including the positive electrode active materials of Examples 1 to 7 and Comparative Examples 1 to 4 are equal, but the initial efficiencies of the positive electrodes including the positive electrode active materials of Examples 1 to 7 above are 87% to 89%. That is, it may be seen that when the positive electrode active material according to the present invention is applied, an initial efficiency having a specific range may be performed, and at the same time, a lithium precipitation phenomenon caused by a difference in a rate performance with the negative electrode in which a silicon-based negative electrode active material was applied may be controlled, thereby increasing the capacity maintenance rate, and improving the high-temperature life characteristics.

## Claims

1. A positive electrode comprising:
a lithium-nickel-based transition metal oxide having at least one form of a single particle composed of one single nodule, and a pseudo-single particle, which is a composite body of 30 or less nodules, and
a positive electrode active material having a D₅₀ of 4.5 µm to 6.7 µm, and a crystal strain of 320x10⁻⁶ or less.

2. The positive electrode of claim 1, wherein the positive electrode active material has a D₅₀ of 5.5 µm to 6.5 µm.

3. The positive electrode of claim 1, wherein the positive electrode active material has a strain of 220x10⁻⁶ to 320x10⁻⁶.

4. The positive electrode of claim 1, wherein the positive electrode active material has a cation mixing ratio of 0.7 at% to 1.2 at%.

5. The positive electrode of claim 1, wherein the positive electrode active material has an average grain size of at least 160 nm.

6. The positive electrode of claim 1, wherein Ni among all the transition metals in the lithium-nickel-based transition metal oxide has a molar ratio of at least 80 mol%.

7. The positive electrode of claim 1, wherein the lithium-nickel-based transition metal oxide is represented by Formula 1 below.
[Formula 1] Li₁₊ₓNiₐCo_{b}M¹_{c}M²_{d}O₂
where M¹ is Mn, Al, or a combination thereof, M² is at least one selected from the group consisting of Ba, Ca, Zr, Ti, Mg, Ta, Nb, and Mo, 0≤x≤0.50, 0.80≤a<1.00, 0<b<0.20, 0<c<0.20, and 0≤d≤0.20.

8. The positive electrode of claim 1, wherein the positive electrode has an initial charging capacity of at least 242 mAh/g.

9. The positive electrode of claim 1, wherein the positive electrode has an initial efficiency of 87% to 89%.

10. A lithium secondary battery comprising:
the positive electrode of the above claim 9;
a negative electrode; and
an electrolyte.

11. The lithium secondary battery of claim 10, wherein the negative electrode comprises a silicon-based negative electrode active material, a carbon-based negative electrode active material, or a combination thereof.

12. The lithium secondary battery of claim 10, wherein the negative electrode comprises a silicon-based negative electrode active material and a carbon-based negative electrode active material.

13. The lithium secondary battery of claim 10, wherein the lithium secondary battery has a capacity maintenance rate of at least 88.8% after 50 cycles of charging and discharging are performed with each cycle consisting of charging up to 4.25 V at 0.5 C in a CC-CV mode at 45°C, followed by discharging to 3.0 V at 1.0 C.
